# EUROPEAN PATENT APPLICATION

(11) **EP 4 404 721 A1**
(43) Date of publication of application: **24.07.2024**
(21) Application number: 22870331.0
(22) Date of filing: 16.09.2022
(51) Int. Cl.: H10K 99/00, H10K 50/80, G09F 9/30, G09F 9/33

(54) **DISPLAY DEVICE AND MANUFACTURING METHOD THEREFOR**

(30) Priority: 17.09.2021 KR 20210125127
(71) Applicant: Tovis Co., Ltd., Incheon 21999 (KR)
(72) Inventor: KIM, Yong Beom, Incheon 22003 (KR)
(74) Representative: Taruttis, Tilman
(86) International application number: PCT/KR2022/013844
(87) International publication number: WO 2023/043247

(57) **Abstract**

A display device includes a first substrate in which a first surface and a second surface opposite to the first surface are defined, a second substrate which faces the first substrate and in which a third surface facing the second surface and a fourth surface opposite to the third surface, and a light emitting element layer which is disposed on the third surface of the second substrate, wherein the first substrate is formed to be entirely slimmed. The second substrate includes an upper slimming portion slimmed in a thickness direction from the fourth surface, and a thickness of the entirely slimmed first substrate is smaller than a thickness of the upper slimming portion.

## Description

### [Technical Field]

The present disclosure relates to a display device and a manufacturing method thereof.

### [Background Art]

Display devices are electronic devices for displaying videos. Recently, as technology develops, research into curved display devices has been conducted in order to increase a sense of immersion in videos.

The curved display device provides the sense of immersion because it makes a viewer feel as if he/she is positioned in a space by curving a viewing surface of the video. A general curved display device may be fabricated by fabricating a flat panel display device at a small thickness and then curving a display panel.

In order to fabricate the curved display device, a display device may be designed and fabricated to have a small thickness when it is initially fabricated. Otherwise, the curved display device may be fabricated by performing a process (hereinafter referred to as "slimming") such as etching or polishing on a produced display device so that a thickness of the display device is reduced and then curving the display device. An etching process for slimming may be performed by disposing masking members for preventing damage to a conductive pattern and a circuit portion due to an etchant and spraying the etchant or making the etchant flow onto target members to be etched.

### [Disclosure]

### [Technical Problem]

Aspects of the present disclosure provide a display device that has a small curvature of 50 mm or less and has a reduced damage possibility during fabrication.

Aspects of the present disclosure also provide a manufacturing method of a display device that has a small curvature of 50 mm or less and has an improved damage possibility during fabrication.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [Technical Solution]

According to an aspect of the present disclosure, there is provided a display device including: a first substrate in which a first surface and a second surface opposite to the first surface are defined; a second substrate which faces the first substrate and in which a third surface facing the second surface and a fourth surface opposite to the third surface; and a light emitting element layer which is disposed on the third surface of the second substrate, wherein the first substrate is formed to be entirely slimmed, the second substrate includes an upper slimming portion slimmed in a thickness direction from the fourth surface, and a thickness of the entirely slimmed first substrate is smaller than a thickness of the upper slimming portion.

According to another aspect of the present disclosure, there is provided a display device and a manufacturing method thereof, including: preparing a first substrate in which a first surface and a second surface opposite to the first surface are defined, a second substrate which faces the first substrate and in which a third surface and a fourth surface opposite to the third surface are defined, and a light emitting element layer which is disposed on the third surface of the second substrate; slimming the first substrate; and slimming the second substrate, wherein a thickness of the slimmed first substrate is smaller than a thickness of the slimmed second substrate.

Detailed contents of other embodiments are described in a detailed description and are illustrated in the drawings.

### [Advantageous Effects]

With a display device and a manufacturing method thereof according to embodiments, the display device may have a small curvature of 50 mm or less and have an improved damage possibility during fabrication.

The effects of the present disclosure are not limited to the aforementioned effects, and various other effects are included in the present specification.

### [Description of Drawings]

FIG. 1 is a plan view of a display device according to an embodiment;
FIG. 2 is a plan view illustrating a second substrate, a driving connection film, and a driving circuit board of the display device of FIG. 1 in detail;
FIG. 3 is a plan view illustrating a first substrate of the display device of FIG. 1 in detail;
FIG. 4 is a plan view illustrating the display device of FIG. 1 in detail;
FIG. 5 is a cross-sectional view taken along line I-I' of FIG. 4;
FIG. 6 is an enlarged cross-sectional view of area A of FIG. 5;
FIG. 7 is a cross-sectional view taken along line II-II' of FIG. 4;
FIG. 8 is a cross-sectional view taken along line III-III' of FIG. 4;
FIG. 9 is a cross-sectional view illustrating a state in which the driving connection film of FIG. 8 is bent;
FIGS. 10 and 11 are cross-sectional views illustrating a state in which the display device of FIG. 1 is folded;
FIGS. 12 and 13 are cross-sectional views illustrating a state in which the display device of FIG. 1 is folded;
FIGS. 14 to 25 are cross-sectional views illustrating process steps of a manufacturing method of a display device according to an embodiment;
FIG. 26 is a plan view of a second substrate according to another embodiment;
FIG. 27 is a cross-sectional view of a display device including the second substrate of FIG. 26;
FIG. 28 is a plan view of a second substrate according to still another embodiment; and
FIGS. 29 and 30 are cross-sectional views of a display device including the second substrate of FIG. 28.

### [Mode for Invention]

Advantages and features of the present disclosure and methods for accomplishing these advantages and features will become apparent from embodiments to be described later in detail with reference to the accompanying drawings. However, the present disclosure is not limited to embodiments disclosed below, and may be implemented in various different forms, these embodiments will be provided only in order to make the present disclosure complete and allow one of ordinary skill in the art to which the present disclosure pertains to completely recognize the scope of the present disclosure, and the present disclosure will be defined by the scope of the claims.

A phrase "one element or layer 'on' another element or layer" includes both of a case where one element or layer is directly on another element or layer and a case where one element or layer is on another element or layer with the other layer or element interposed therebetween. Throughout the specification, the same components will be denoted by the same reference numerals.

The terms "first", "second", and the like are used to describe various components, but these components are not limited by these terms. These terms are used only in order to distinguish one component from other components. Accordingly, a first component mentioned below may be a second component within the technical spirit of the present disclosure.

Hereinafter, embodiments will be described with reference to the accompanying drawings.

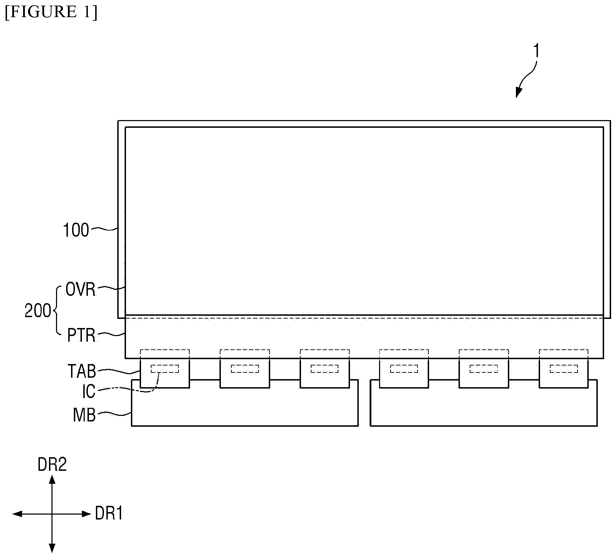

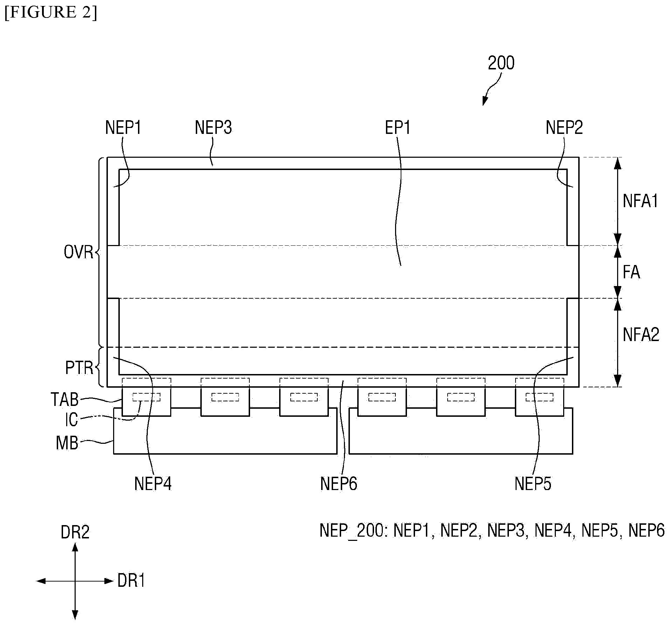

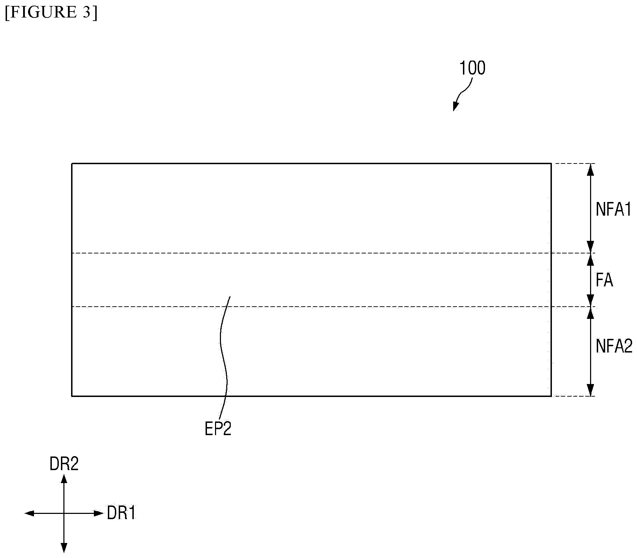

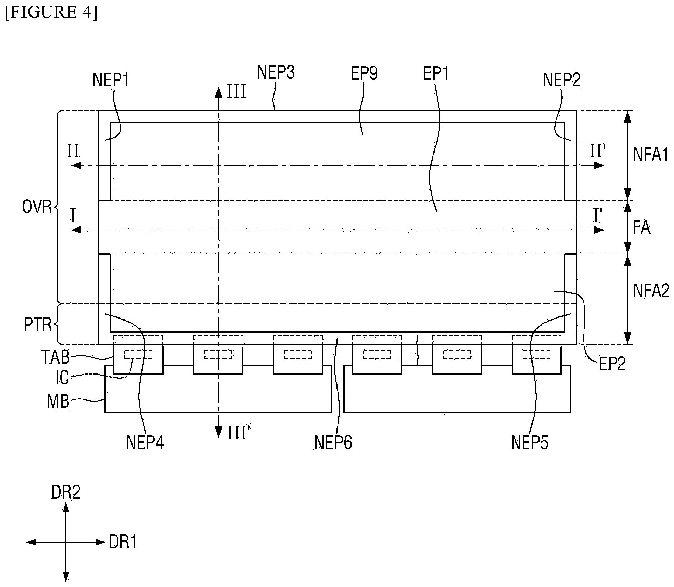

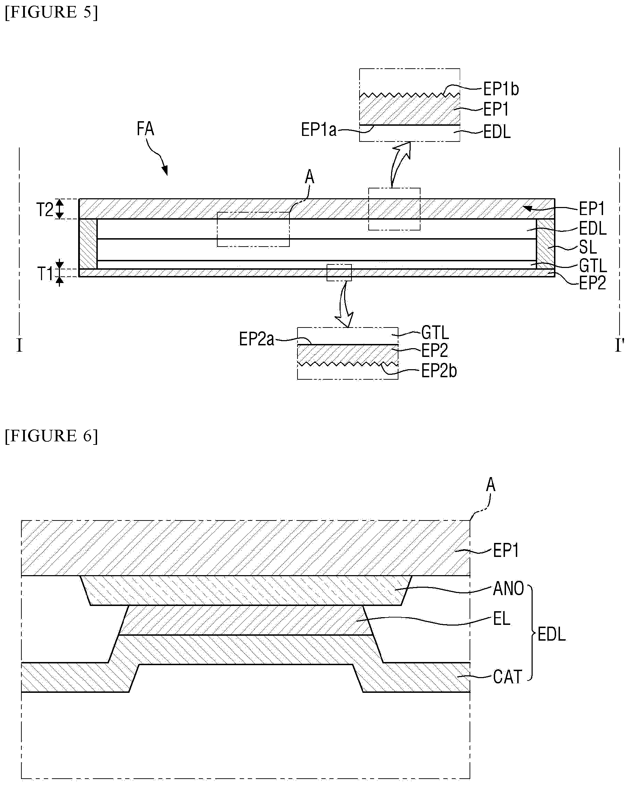

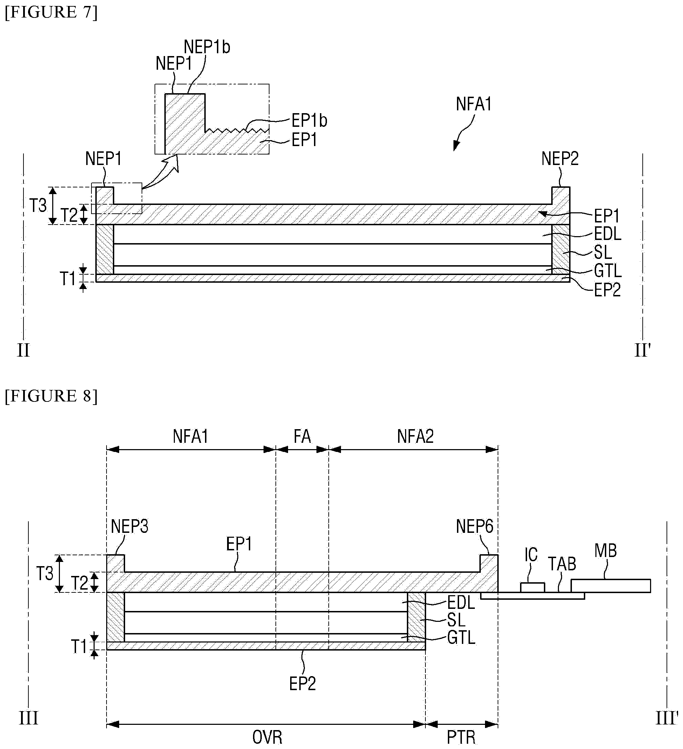

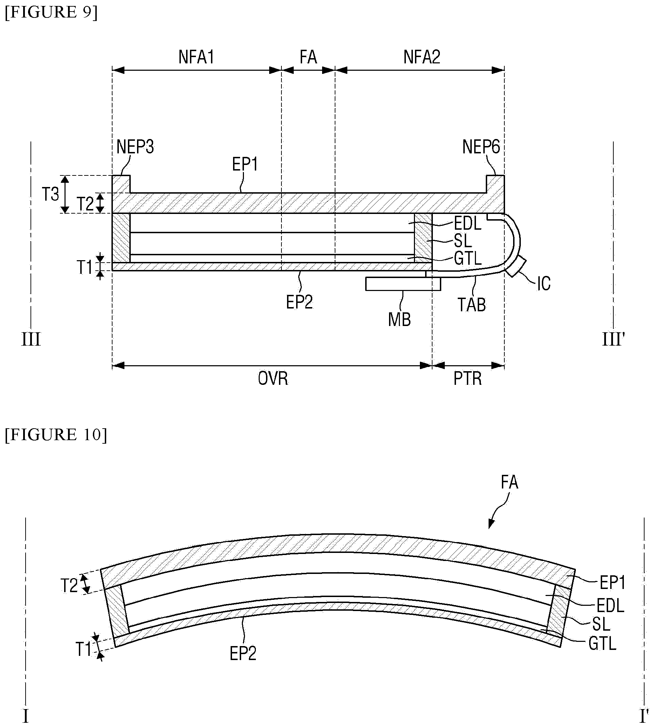

FIG. 1 is a plan view of a display device according to an embodiment. FIG. 2 is a plan view illustrating a second substrate, a driving connection film, and a driving circuit board of the display device of FIG. 1 in detail. FIG. 3 is a plan view illustrating a first substrate of the display device of FIG. 1 in detail. FIG. 4 is a plan view illustrating the display device of FIG. 1 in detail. FIG. 5 is a cross-sectional view taken along line I-I' of FIG. 4. FIG. 6 is an enlarged cross-sectional view of area A of FIG. 5. FIG. 7 is a cross-sectional view taken along line II-II' of FIG. 4. FIG. 8 is a cross-sectional view taken along line III-III' of FIG. 4. FIG. 9 is a cross-sectional view illustrating a state in which the driving connection film of FIG. 8 is bent.

Referring to FIGS. 1 to 9, when a display device 1 is a device that includes a display area displaying an image or a video, it may be interpreted as a display device regardless of a main purpose, an added function, a name, or the like, of the device. For example, the display device 1 may include small game machines, large game machines such as slot machines used in casinos, electronic whiteboards, e-books, smartphones, mobile phones, tablet personal computers (PCs), personal digital assistants (PDAs), portable multimedia players (PMPs), televisions, monitors of personal computers, laptop computers, vehicle navigation devices, vehicle instrument boards, digital cameras, camcorders, external billboards, electric signs, various medical devices, various inspection devices, various home appliances including display units, such as refrigerators and washing machines, or Internet of Things (IoT) devices, but is not limited thereto.

In an embodiment, the display device 1 may have a rectangular shape including two long sides (upper and lower sides when viewing a display surface in the drawings) opposing each other and two short sides (left and right sides when viewing the display surface in the drawings) opposing each other. Based on a direction of a normal display screen, the long sides of the display device 1 may be disposed transversely as illustrated in FIG. 1, but may also be disposed longitudinally.

In the drawings, three directional axes are defined. A first direction DR1 may be an extension direction of the long side of the display device, a second direction DR2 may be an extension direction of the short side of the display device, and a third direction DR3 may be a thickness direction of the display device. One side in the first direction DR1 may be defined as a short side of the right side of the display device 1, the other side in the first direction DR1 may be defined as a short side of the left side of the display device 1, one side in the second direction DR2 may be defined as a long side of the upper side of the display device 1, and the other side in the second direction DR2 may be defined as a long side of the lower side of the display device 1, but it is to be understood that the definition of the direction axes described above are relative.

An organic light emitting display (OLED) may be used as the display device 1. In the following embodiment, an organic light emitting display will be described as an example of the display device 1, but the display device 1 is not limited thereto, and may also be applied to an electrophoretic display (EPD), a liquid crystal display (LCD), an inorganic electroluminescence (EL) display, a plasma display panel (PDP), a field emission display (FED), and the like.

The display device 1 may include a first substrate 100, a second substrate 200 facing the first substrate 100, and a light emitting element layer EDL disposed between the first substrate 100 and the second substrate 200. A sealing member SL may be disposed on edges of the first substrate 100 and the second substrate 200 to couple the first substrate 100 and the second substrate 200 to each other and protect the light emitting element layer EDL from the outside.

The display device 1 according to an embodiment may be a bottom emission-type organic light emitting display device. In FIG. 5, light emitted from the light emitting element layer EDL may be emitted in a direction toward the second substrate 200. That is, the second substrate 200 may be disposed above the first substrate 100 based on a display direction.

The second substrate 200 may protrude relatively from the first substrate 100. For example, an end of the other side of the second substrate 200 in the second direction DR2 may protrude more than an end of the other side of the first substrate 100 in the second direction DR2. Hereinafter, a region of the second substrate 200 protruding from the first substrate 100 on the other side in the second direction DR2 may defined as a protrusion region PTR of the second substrate 200, and a region of the second substrate 200 overlapping the first substrate 100 in the thickness direction may be defined as an overlap region OVR of the second substrate 200.

The protrusion region PTR may not be disposed to overlap the first substrate 100. A driver driving the light emitting element layer EDL disposed between the second substrate 200 and the first substrate 100 may be disposed on or attached to the protrusion region PTR of the second substrate 200. For example, the driver may include a driving connection film TAB and a driving circuit board MB connected to the driving connection film TAB, and the driving connection film TAB of the driving connection film TAB and the driving circuit board MB may be attached onto the protrusion region PTR of the second substrate 200. The second substrate 200 may include one surface facing the first substrate 100 and the other surface opposite to the one surface. The other surface may be a display surface of the display device 1. Likewise, the first substrate 100 may include one surface facing the second substrate 200 and the other surface opposite to the one surface.

The driving connection film TAB may be attached to one surface of the second substrate 200. A driving chip IC may be disposed on the driving connection film TAB.

In an embodiment, the first substrate 100 may include an Invar alloy, and the second substrate 200 may include glass, quartz, or the like. Although not illustrated in FIGS. 5 and 7 to 9, a circuit driving layer may be further included between the first substrate 100 and the light emitting element layer EDL. The circuit driving layer may drive the light emitting element layer EDL by providing a driving signal provided from the driver to the light emitting element layer EDL. The circuit driving layer may include a plurality of lines, metals, semiconductor layers, insulating films, and the like. The circuit driving layer is well known in the art, and a detailed description thereof will thus be omitted.

The driving connection film TAB serves to connect the first substrate 100 and the driving circuit board MB or a main circuit board to each other. The driving connection film TAB may be attached to one surface of the second substrate 200 via a conductive anisotropic film. However, the present disclosure is not limited thereto, and the driving connection film TAB may also be directly attached onto one surface of the second substrate 200 through soldering, ultrasonic bonding, or the like. The driving connection film TAB is a film including a signal line, and may include a flexible film. The driving connection film TAB may be a flexible printed circuit board (FPC), a tab, a connect film, or the like.

The driving circuit board MB may be attached to one end of the driving connection film TAB. The driving connection film TAB and the driving circuit board MB may be attached to each other by a conductive anisotropic film interposed therebetween. When the soldering, the ultrasonic bonding, or the like, is used to couple the driving connection film TAB and the driving circuit board MB to each other, the conductive anisotropic film may be omitted.

The driving circuit board MB may be a printed circuit board (PCB). In some embodiments, the driving chip IC may be disposed on the driving circuit board MB.

A case where the driving circuit board MB and the driving connection film TAB connecting the driving circuit board MB are disposed on an end of the other side of the second substrate 200 in the second direction DR2 has been illustrated in the drawings, but the driving circuit board MB and the driving connection film TAB may also be disposed on an end of one side of the second substrate 200 in the second direction DR2 or disposed on an end of one side or an end of the other side of the first direction DR1. In addition, a plurality of driving circuit boards MB and a plurality of driving connection films TAB may be provided and attached adjacent to two or more sides of the second substrate 200.

In an embodiment, one driving circuit board MB may be connected to the second substrate 200 by the plurality of driving connection films TAB. That is, as illustrated in FIG. 1, the plurality of driving connection films TAB having a smaller width than one driving circuit board MB may be attached to the one driving circuit board MB. Neighboring driving connection films TAB may be spaced apart from each other.

Meanwhile, the first substrate 100 according to an embodiment may include a lower slimming portion EP2, and the second substrate 200 may include an upper slimming portion EP1 and an upper non-slimming portion NEP_200 surrounding the upper slimming portion EP1 in plan view. In an embodiment, an area of the upper slimming portion EP1 in plan view may be greater than an area of the lower slimming portion EP2 in plan view. However, the present disclosure is not limited thereto, and an area of the upper slimming portion EP1 in plan view may be the same as or greater than an area of the lower slimming portion EP2 in plan view. The lower slimming portion EP2 may be an area formed by entirely slimming the second substrate 200. That is, the area of the lower slimming portion EP2 in plan view is the same as an area of the second substrate 200 in plan view.

A thickness of the upper non-slimming portion NEP_200 may be greater than a thickness of the upper slimming portion EP1. In other words, the thickness of the upper slimming portion EP1 may be smaller than the thickness of the upper non-slimming portion NEP_200.

The upper slimming portion EP1 may include a first upper slimming portion extending along the first direction DR1. The first upper slimming portion may completely extend from an edge of the other side of the second substrate 200 in the first direction DR1 to an edge of one side of the second substrate 200 in the first direction DR1 in plan view. In plan view, the upper slimming portion may include long sides extending along the first direction DR1 and short sides extending along the second direction DR2. A short side of one side of the first upper slimming portion in the first direction DR1 may be on the same extension line as a short side of one side of the second substrate 200 in the first direction DR1, and a short side of the other side of the first upper slimming portion in the first direction DR1 may be on the same extension line as a short side of the other side of the second substrate 200 in the first direction DR1.

The upper slimming portion EP1 may further include a second upper slimming portion positioned on one side of the first upper slimming portion in the second direction DR2 and a third upper slimming portion positioned on the other side of the first upper slimming portion in the second direction DR2. Each of a width of the second upper slimming portion in the first direction DR1 and a width of the third upper slimming portion in the first direction DR1 may be smaller than a width of the first upper slimming portion in the first direction DR1. A long side of one side of the first upper slimming portion in the second direction DR2 may be in direct contact with the second upper slimming portion, and a long side of the other side of the first upper slimming portion in the second direction DR2 may be in direct contact with the third upper slimming portion. The second upper slimming portion may be substantially in contact with the long side of one side of the first upper slimming portion in the second direction DR2, but may expose an end of one side in the first direction DR1 and an end of the other side in the first direction DR, of the long side of one side of the first upper slimming portion in the second direction DR2. The third upper slimming portion may be substantially in contact with the long side of the other side of the first upper slimming portion in the second direction DR2, but may expose an end of one side in the first direction DR1 and an end of the other side in the first direction DR, of the long side of the other side of the first upper slimming portion in the second direction DR2.

Each of the second and third upper slimming portions may include long sides extending along the first direction DR1 and short sides extending along the second direction DR2.

The upper non-slimming portion NEP_200 may include a first non-slimming portion NEP1, a second non-slimming portion NEP2, a third non-slimming portion NEP3, a fourth non-slimming portion NEP4, a fifth non-slimming portion NEP5, and a sixth non-slimming portion NEP6.

The first non-slimming portion NEP1 may be disposed on the other side in the first direction DR1 of a short side of the other side of the second upper slimming portion in the first direction DR1 and on one side in the second direction DR2 of the long side of one side of the first upper slimming portion in the second direction DR2.

The second non-slimming portion NEP2 may be disposed on one side in the first direction DR1 of a short side of one side of the second upper slimming portion in the first direction DR1 and on one side in the second direction DR2 of the long side of one side of the first upper slimming portion in the second direction DR2.

The third non-slimming portion NEP3 may be directly connected to the first and second non-slimming portions NEP1 and NEP2, and be positioned on one side of the second direction DR2 of a long side of one side of the second upper slimming portion in the second direction DR2.

The fourth non-slimming portion NEP4 may be disposed on the other side in the first direction DR1 of a short side of the other side of the third upper slimming portion in the first direction DR1 and on the other side in the second direction DR2 of the long side of the other side of the first upper slimming portion in the second direction DR2.

The fifth non-slimming portion NEP5 may be disposed on one side in the first direction DR1 of a short side of one side of the third upper slimming portion in the first direction DR1 and on the other side in the second direction DR2 of the long side of the other side of the first upper slimming portion in the second direction DR2.

The sixth non-slimming portion NEP6 may be directly connected to the fourth and fifth non-slimming portions NEP4 and NEP5, and be positioned on the other side of the second direction DR2 of a long side of the other side of the third upper slimming portion in the second direction DR2.

The overlap region OVR may include the non-slimming portions NEP1, NEP2, and NEP3, a portion of the fourth non-slimming portion NEP4, a portion of the fifth non-slimming portion NEP5, and the first upper slimming portion, the second upper slimming portion, and a portion of the third upper slimming portion of the upper slimming portion EP1 of the second substrate 200.

The protrusion region PTR may include a portion of the fourth non-slimming portion NEP4, a portion of the fifth non-slimming portion NEP5, the sixth non-slimming portion NEP6, and a portion of the third upper slimming portion.

Meanwhile, a folding area FA and non-folding areas NFA1 and NFA2 may be defined in the display device 1 according to an embodiment. The folding area FA may include the upper slimming portion EP1 and the lower slimming portion EP2, and a first non-folding area NFA1 may include the first to third non-slimming portions NEP1 to NEP3. A second non-folding area NFA2 may include the fourth to sixth non-slimming portions NEP4 to NEP6. The folding area FA may have the same area as an area of the upper slimming portion of the upper slimming portion EP1, the width of the first upper slimming portion of the upper slimming portion EP1 in the first direction DR1 may be the same as a width of the lower slimming portion EP2 in the first direction DR1, and the width of the second upper slimming portion of the upper slimming portion EP1 in the first direction DR1 may be smaller than the width of the first upper slimming portion in the first direction DR1 and smaller than the width of the lower slimming portion EP2 in the first direction DR1.

The first substrate 100 and the second substrate 200 may be folded around the folding area FA. The non-folding areas NFA1 and NFA2 excluding the folding area FA are not folded, and may be maintained in an unfolded state. A folding operation of the first substrate 100 and the second substrate 200 is illustrated in FIGS. 10 and 11 and FIGS. 12 and 13.

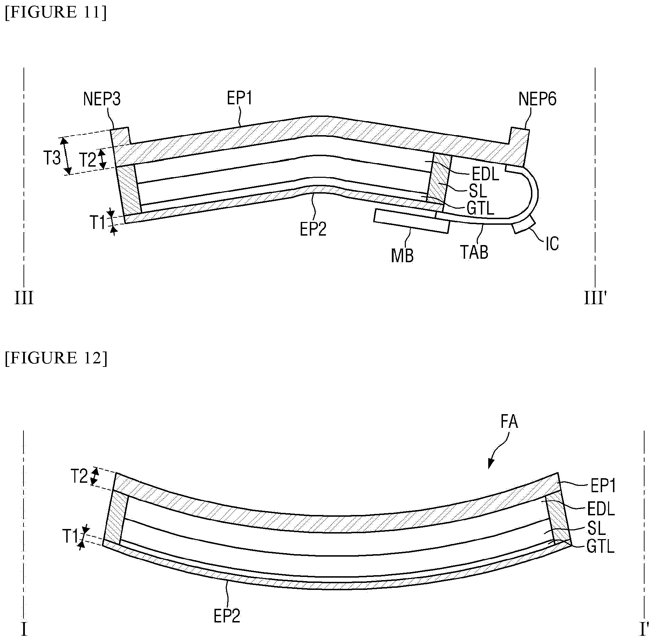

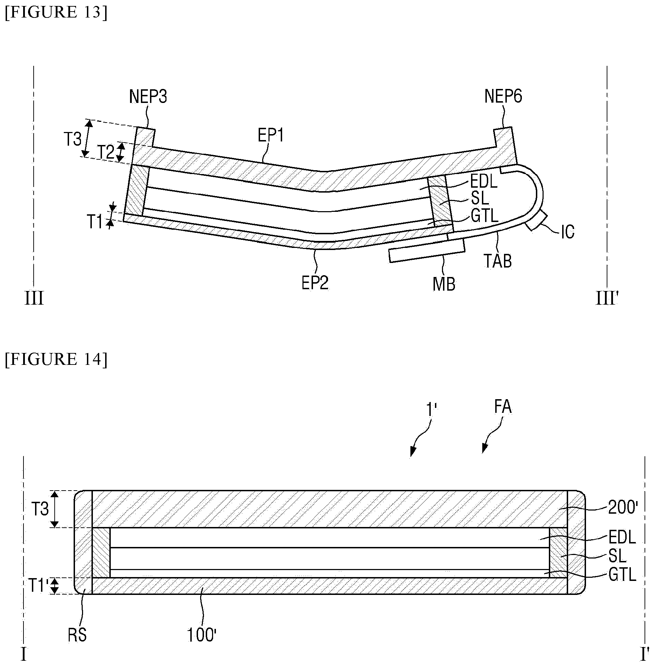

FIGS. 10 and 11 are cross-sectional views illustrating a state in which the display device of FIG. 1 is folded. FIGS. 12 and 13 are cross-sectional views illustrating a state in which the display device of FIG. 1 is folded.

The folding area FA may be folded with a predetermined curvature. A side surface shape of the folding area FA folded with the predetermined curvature may be a curved shape. The non-folding area NFA distinguished from the folding area FA may not be folded. A side surface shape of the non-folding area NFA that is not folded may be a straight line shape.

In FIGS. 10 and 11, each of the first substrate 100 and the second substrate 200 may be folded in the folding area FA so as to have a cross-section convex in an upward direction, and in FIGS. 12 and 13, each of the first substrate 100 and the second substrate 200 may be folded in the folding area FA so as to have a cross-section convex in a downward direction.

In the folding area FA, the substrates 100 and 200 may have predetermined radii of curvature from a center point. In FIGS. 10 and 11, a radius of curvature of the first substrate 100 may be smaller than a radius of curvature of the second substrate 200, and in FIGS. 12 and 13, a radius of curvature of the first substrate 100 may be greater than a radius of curvature of the second substrate 200. In an embodiment, each of the curvature radii of the first substrate 100 and the second substrate 200 may be 50 mm or less.

As illustrated in FIG. 5, the lower slimming portion EP2 may have a first thickness T1, and the upper slimming portion EP1 may have a second thickness T2.

As illustrated in FIGS. 5 and 7 to 9, an absorption plate GTL may be disposed between one surface of the first substrate 100 and the light emitting element layer EDL. The absorption plate GTL may function to remove moisture permeating from the outside into the light emitting element layer EDL.

In an embodiment, the first thickness T1 may be smaller than the second thickness T2. In other words, the second thickness T2 may be greater than the first thickness T1. For example, the first thickness T1 may be 0.005 mm to 0.01 mm. The lower slimming portion EP2 may be formed by slimming an Invar alloy (about 0.05 mm before being slimmed). For example, the second thickness T2 may be 0.7 mm.

As illustrated in an enlarged view of FIG. 5, the lower slimming portion EP2 may include a first surface EP2a facing the absorption plate GTL and a second surface EP2b opposite to the first surface EP2a. Since the second surface EP2b of the lower slimming portion EP2 is an entirely slimmed surface, a roughness of the second surface EP2b may be greater than a roughness of the first surface EP2a. In some embodiments, depending on a slimming method, the roughness of the second surface EP2b may be smaller than the roughness of the first surface EP2a.

As illustrated in another enlarged view of FIG. 5, the upper slimming portion EP1 may include a first surface EP1a facing the light emitting element layer EDL and a second surface EP1b opposite to the first surface EP1a. Since the second surface EP1b of the upper slimming portion EP1 is an entirely slimmed surface, a roughness of the second surface EP1b may be greater than a roughness of the first surface EP1a. In some embodiments, depending on a slimming method, the roughness of the second surface EP1b may be smaller than the roughness of the first surface EP1a.

As illustrated in FIG. 6, the light emitting element layer EDL may be disposed on the other surface of the upper slimming portion EP1. The light emitting element layer EDL may include an anode electrode ANO disposed on the other surface of the upper slimming portion EP1, a common electrode CAT facing the anode electrode ANO, and an organic layer EL disposed between the anode electrode ANO and the common electrode CAT. The common electrode CAT may include a reflective electrode. The anode electrode ANO may include a transparent or translucent electrode. Light emitted through the organic layer EL may be provided in a direction toward the anode electrode ANO or may be reflected from the cathode electrode CAT and provided in the direction toward the anode electrode ANO.

As illustrated in FIG. 7, each of the first and second non-slimming portions NEP1 and NEP2 may have a third thickness T3. The third thickness T3 may be greater than the second thickness T2. For example, the third thickness T3 may be 0.05 mm to 0.1 mm.

Meanwhile, as illustrated in the enlarged view of FIG. 7, the first non-slimming portion NEP1 may include a first surface in contact with the sealing member SL and a second surface NEP1b opposite to the first surface. The first non-slimming portion NEP1 is not slimmed, while the upper slimming portion EP1 is slimmed, and thus, a roughness of the second surface NEP1b of the first non-slimming portion NEP1 may be smaller than the roughness of the second surface EP1b of the upper slimming portion EP1. In other words, the roughness of the second surface EP1b of the upper slimming portion EP1 may be greater than the roughness of the second surface NEP1b of the first non-slimming portion NEP1.

As illustrated in FIG. 8, a thickness T3 of each of the third and sixth non-slimming portions NEP3 and NEP6 may be greater than the thickness T2 of the upper slimming portion EP1.

As illustrated in FIG. 9, one end of the driving connection film TAB may be attached to the other surface of the second substrate 200, and the other end of the driving connection film TAB may be attached to the other surface of the first substrate 100. Through this, the driving circuit board MB attached to the other end of the driving connection film TAB may be disposed to overlap the other surface of the first substrate 100.

As described above, in the display device 1 according to the present embodiment, in order to fold the first and second substrates 100 and 200 in the folding area FA, the upper slimming portion EP1 included in the folding area FA is formed in the second substrate 200 that is rigid. The first substrate 100 includes the Invar alloy more flexible than a material of the second substrate 200, and may thus be folded in the folding area FA without being slimmed. However, as in the present embodiment, slimming of the first substrate 100 is indispensable in order to fold the first substrate 100 with a radius of curvature of approximately 50 mm. According to the present embodiment, the first substrate 100 is entirely slimmed, such that the display device 1 may be folded with the radius of curvature of approximately 50 mm.

Hereinafter, a manufacturing method of a display device according to an embodiment will be described.

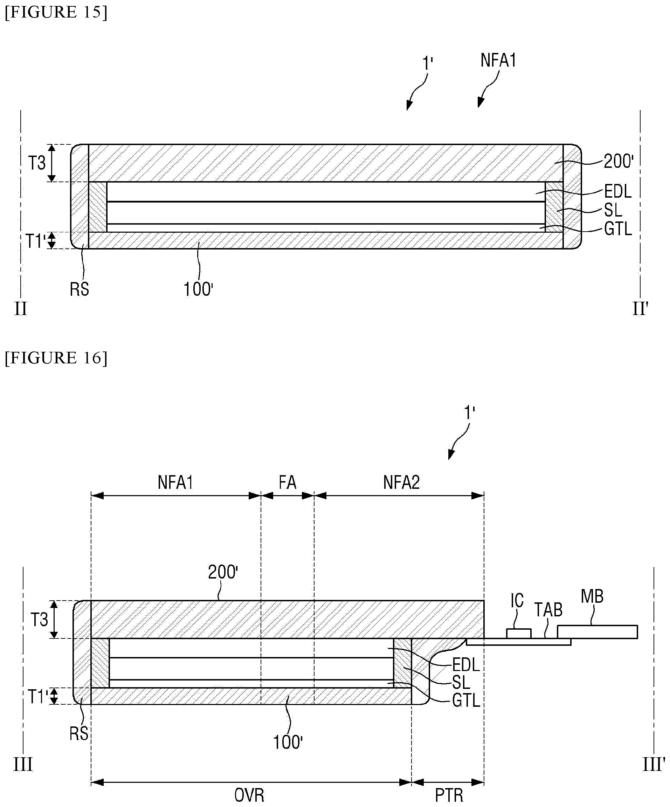

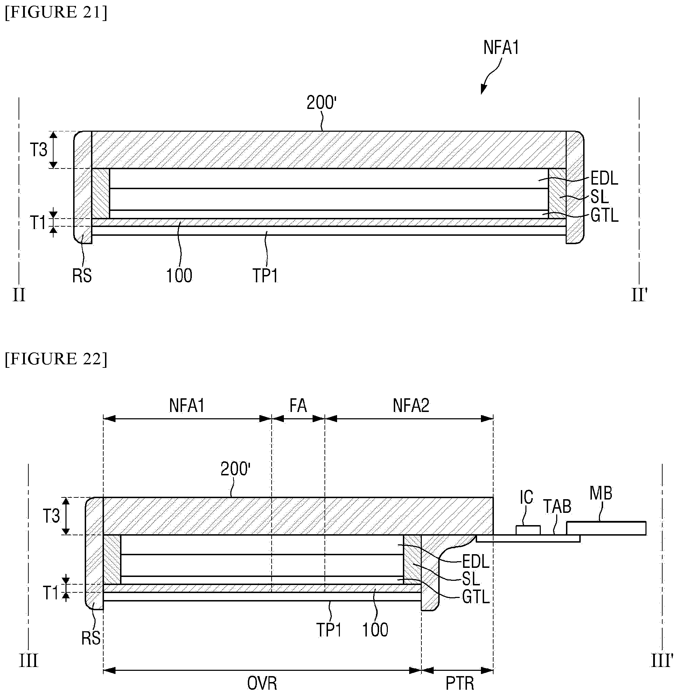

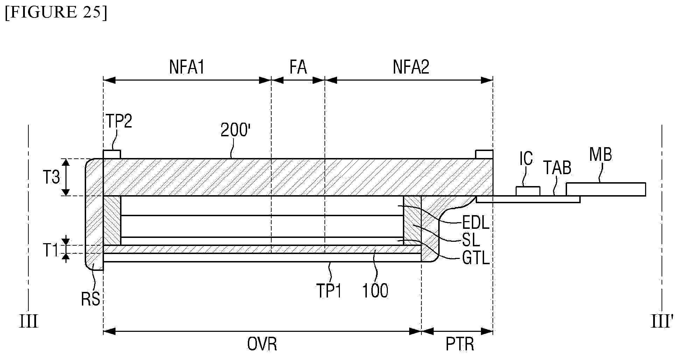

FIGS. 14 to 25 are cross-sectional views illustrating process steps of a manufacturing method of a display device according to an embodiment. A description will be provided with reference to FIGS. 14 to 25 in conjunction with FIGS. 5 and 7 to 9.

First, as illustrated in FIGS. 14 to 16, a first substrate 100', a second substrate 200' facing the first substrate 100', a light emitting element layer EDL disposed on one surface of the second substrate 200', an absorption plate GTL disposed on one surface of the first substrate 100', and a sealing member SL disposed on edges of the first substrate 100' and the second substrate 200' between the first substrate 100' and the second substrate 200' are prepared. The first substrate 100' has a thickness T1' greater than the thickness T1 of the first substrate 100 in FIG. 5.

Subsequently, a resin RS is applied onto side surfaces of the first substrate 100' and the second substrate 200'. The resin RS may be in direct contact with the side surfaces of the first substrate 100' and the second substrate 200' and side surfaces of the sealing member SL. The sealing member SL may be in contact with the other surface of the second substrate 200' in the second non-folding area NFA2.

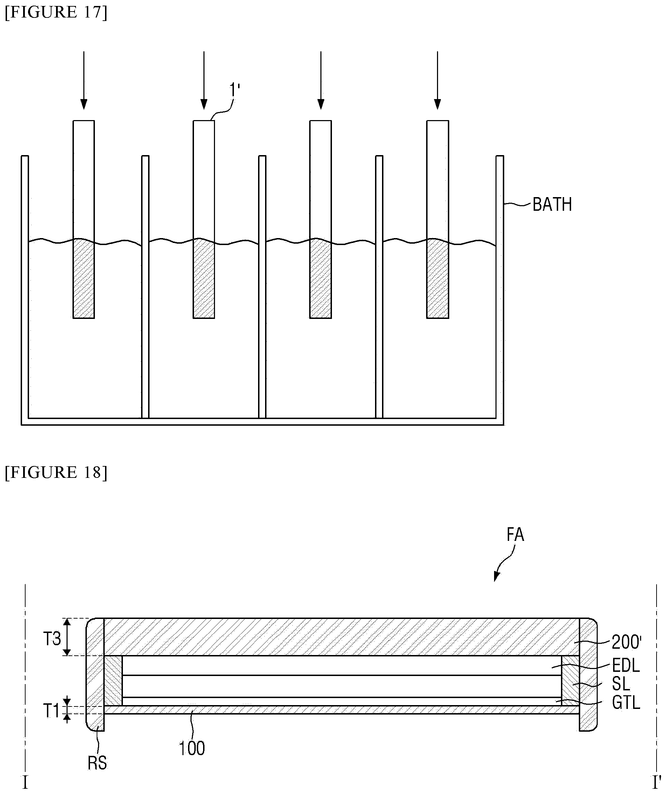

Subsequently, as illustrated in FIG. 17, the first substrate 100' is primarily etched. The lower slimming portion EP2 of FIG. 5 is formed through the primary etching of the first substrate 100'.

The primary etching may include a process of putting a target display device 1' including target substrates 100' and 200' into an etching bath. The etching bath may be filled with a primary etchant. A first etch ratio of the first substrate 100' with respect to the primary etchant may be significantly greater than a second etch rate of the second substrate 200' with respect to the primary etchant. Accordingly, the second substrate 200' may be hardly etched or may not be etched at all while the primary etching process is performed.

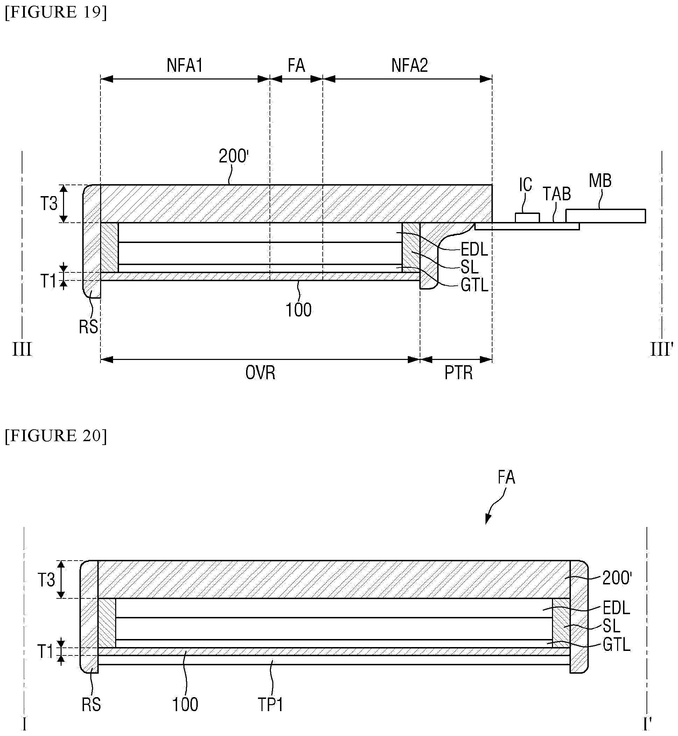

A primary etching result is illustrated in FIGS. 18 and 19.

As the primary etching result, the first substrate 100 has a first thickness T1. The resin RS may protrude more than a lower surface of the first substrate 100 facing a downward direction in the downward direction.

Subsequently, as illustrated in FIGS. 20 to 22, a first masking member TP1 is disposed on a lower surface of an entire area of the primarily etched first substrate 100.

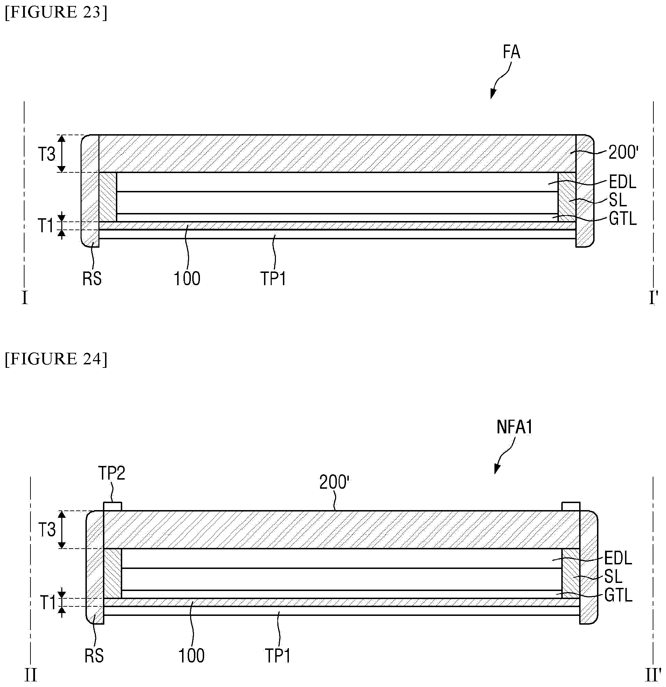

Subsequently, as illustrated in FIGS. 23 to 25, a second masking member TP2 is disposed on portions (areas corresponding to the first and second non-slimming portions NEP1 and NEP2) of a second surface of the first non-folding area NFA1 of the second substrate 200' (a surface opposite to a surface of the second substrate 200' facing the light emitting element layer EDL) and portions (areas corresponding to the third and sixth non-slimming portions NEP3 and NEP6 of FIG. 7) of the other surfaces of the first and second non-folding areas NFA1 and NFA2 of the second substrate 200'.

Subsequently, the second substrate 200' is secondarily etched. In some embodiments, a polishing process may be performed instead of the etching. In an embodiment in which the polishing process is performed, disposition of the above-described sealing member and taping may be omitted, but the present disclosure is not limited thereto.

According to the present embodiment, even though a masking process of the second substrate 200' is not performed during the primary etching process of the first substrate 100', the second substrate 200' may not be etched or may be hardly etched by an etchant used during the primary etching process of the first substrate 100'.

In addition, according to the present embodiment, by performing the secondary etching process of the second substrate 200' after performing the primary etching process of the first substrate 100', it is possible to prevent physical damage to the etched second substrate 200 from occurring in the etching bath in which the etched second substrate 200 is immersed during the etching of the first substrate 100' when etching the first substrate 100' after etching the second substrate 200'.

Hereinafter, other embodiments will be described.

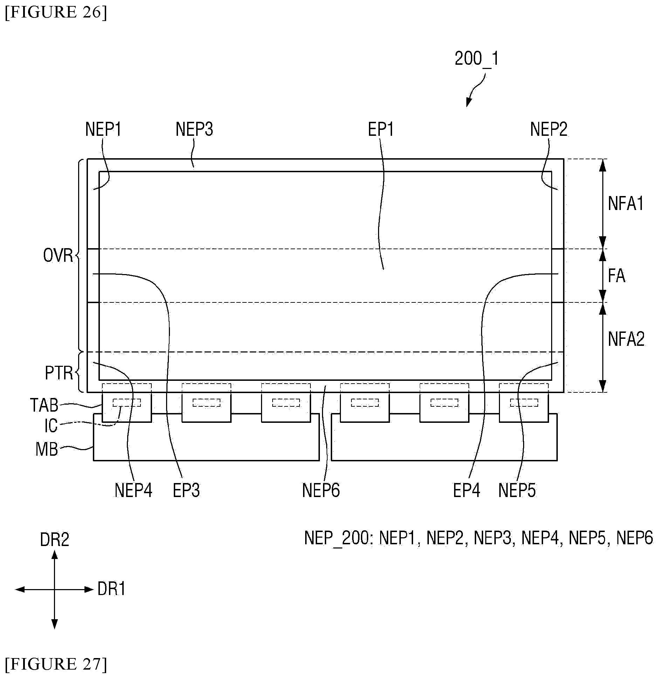

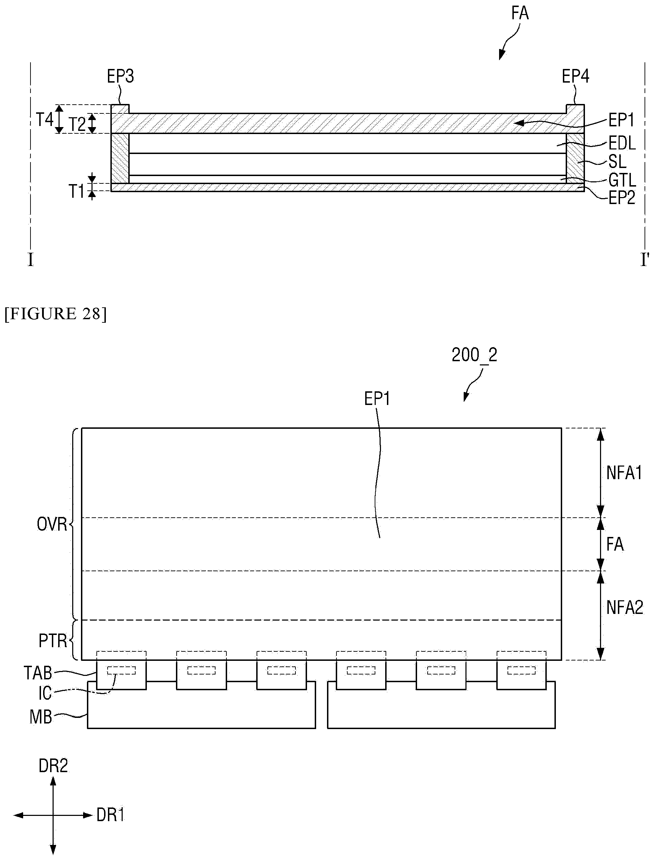

FIG. 26 is a plan view of a second substrate according to another embodiment. FIG. 27 is a cross-sectional view of a display device including the second substrate of FIG. 26.

Referring to FIGS. 26 and 27, a second substrate 200_1 according to the present embodiment is different from the second substrate according to an embodiment of FIGS. 1 to 9 in that it further includes third and fourth slimming portions EP3 and EP4.

More specifically, each of the third and fourth slimming portions EP3 and EP4 may have a fourth thickness T4. The third and fourth slimming portions EP3 and EP4 may be disposed between the first non-slimming portion NEP1 and the fourth non-slimming portion NEP4 and between the second non-slimming portion NEP2 and the fifth non-slimming portion NEP5, respectively. The fourth thickness T4 may be a thickness between the second thickness T2 and the third thickness T3 of FIG. 7. The fourth thickness T4 of each of the third and fourth slimming portions EP3 and EP4 may be smaller than the thickness T3 of each of adjacent non-slimming portions NEP1, NEP2, NEP3, NEP4, NEP5, and NEP6 in FIG. 26.

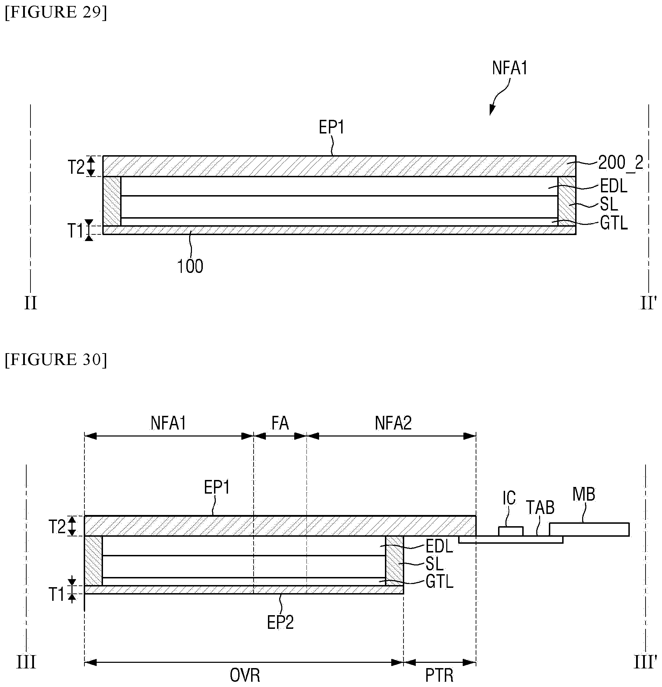

FIG. 28 is a plan view of a second substrate according to still another embodiment. FIGS. 29 and 30 are cross-sectional views of a display device including the second substrate of FIG. 28.

Referring to FIGS. 28 to 30, an upper slimming portion EP1 of a second substrate 200_2 according to the present embodiment may be an area formed by entirely slimming the second surface of the second substrate during the secondary etching process of the second substrate.

Other descriptions have been provided above with reference to FIGS. 1 to 9, and overlapping descriptions will thus be omitted.

The embodiments of the present disclosure have been described hereinabove with reference to the accompanying drawings, but it will be understood by one of ordinary skill in the art to which the present disclosure pertains that various modifications and alterations may be made without departing from the technical spirit or essential feature of the present disclosure. Therefore, it is to be understood that the embodiments described above are illustrative rather than being restrictive in all aspects.

## Claims

1. A display device comprising:
a first substrate in which a first surface and a second surface opposite to the first surface are defined;
a second substrate which faces the first substrate and in which a third surface facing the second surface and a fourth surface opposite to the third surface; and
a light emitting element layer which is disposed on the third surface of the second substrate,
wherein the first substrate is formed to be entirely slimmed,
the second substrate includes an upper slimming portion slimmed in a thickness direction from the fourth surface, and
a thickness of the entirely slimmed first substrate is smaller than a thickness of the upper slimming portion.

2. The display device of claim 1, wherein a thickness of the first substrate is less than 100 µm.

3. The display device of claim 2, wherein a thickness of the upper slimming portion of the second substrate is 300 µm or less.

4. The display device of claim 3, wherein the first substrate includes an Invar alloy, and the second substrate includes glass or quartz

5. The display device of claim 1, wherein a roughness of the first surface of the first substrate is greater than a roughness of the second surface of the first substrate.

6. The display device of claim 1, wherein a roughness of the first surface of the first substrate is smaller than a roughness of the second surface of the first substrate.

7. The display device of claim 5, wherein a roughness of the fourth surface of the upper slimming portion of the second substrate is greater than a roughness of the third surface.

8. The display device of claim 6, wherein a roughness of the fourth surface of the upper slimming portion of the second substrate is smaller than a roughness of the third surface.

9. The display device of claim 7, wherein the first surface of the first substrate includes a first convex portion protruding upward from a first reference surface and a first concave portion recessed downward from the first reference surface, and the fourth surface of the second substrate includes a second convex portion protruding upward from a second reference surface and a second concave portion recessed downward from the second reference surface.

10. The display device of claim 9, wherein the fourth surface of the second substrate further includes a third convex portion whose protrusion height from the second reference surface is different from that of the second convex portion and a third concave portion whose recess depth from the second reference surface is different from that of the second convex portion.

11. The display device of claim 1, wherein the second substrate further includes an upper non-slimming portion surrounding the upper slimming portion in plan view, and the thickness of the upper slimming portion is smaller than a thickness of the upper non-slimming portion.

12. The display device of claim 11, wherein in plan view, the upper slimming portion completely penetrates through the second substrate along a first direction.

13. The display device of claim 12, wherein a folding area extending along the first direction and a non-folding area positioned around the folding area are further defined in the display device.

14. The display device of claim 13, wherein the folding area includes a portion of the lower slimming portion and entirety of the upper slimming portion.

15. The display device of claim 1, wherein the light emitting element layer includes a first electrode positioned on the first surface of the second substrate, a second electrode positioned on the first electrode, and an organic light emitting layer positioned between the first electrode and the second electrode, the second electrode includes a reflective electrode, and the first electrode includes a transparent conductive material.

16. A manufacturing method of a display device, comprising:
preparing a first substrate in which a first surface and a second surface opposite to the first surface are defined, a second substrate which faces the first substrate and in which a third surface and a fourth surface opposite to the third surface are defined, and a light emitting element layer which is disposed on the third surface of the second substrate;
slimming the first substrate; and
slimming the second substrate,
wherein a thickness of the slimmed first substrate is smaller than a thickness of the slimmed second substrate.

17. The manufacturing method of the display device of claim 16, wherein the slimming of the first substrate includes:
applying a sealing member to side surfaces of the first substrate and the second substrate; and
entirely slimming the first substrate.

18. The manufacturing method of the display device of claim 17, wherein the slimming of the second substrate includes:
entirely masking the first surface of the slimmed first substrate;
masking a portion of the fourth surface of the second substrate; and
slimming an exposed portion of the fourth surface of the second substrate.

19. The manufacturing method of the display device of claim 17, wherein the slimming of the second substrate includes:
entirely masking the first surface of the slimmed first substrate; and
entirely slimming the fourth surface of the second substrate.
